# EUROPEAN PATENT SPECIFICATION

(11) **EP 1 269 623 B1**
(45) Date of publication and mention of the grant of the patent: **17.08.2005**
(21) Application number: 01917249.3
(22) Date of filing: 30.03.2001
(51) Int. Cl.: H03F 3/217

(54) **HIGH FREQUENCY SWITCH-MODE POWER AMPLIFIER**
GESCHALTETER HOCHFREQUENZLEISTUNGSVERSTÄRKER
AMPLIFICATEUR D'ENERGIE A MODE DE COMMUTATION HAUTE FREQUENCE

(30) Priority: 31.03.2000 GB 0007825
(43) Date of publication of application: 02.01.2003
(73) Proprietor: LDS Test and Measurement Limited, Royston Hertfordshire SG8 5BQ (GB)
(72) Inventor: LEEDHAM, Robert, Cambridge CB1 8SJ (GB)
(74) Representative: Collins, John David
(86) International application number: PCT/GB2001/001415
(87) International publication number: WO 2001/076061

(56) References cited:
- EP-A- 0 833 443
- WO-A-95/15612
- FR-A- 2 404 337
- FR-A- 2 419 610

## Description

### Field of the Invention

The present invention relates to switch-mode power amplifiers adapted for driving electromagnetic loads including audio loudspeakers, motors and signal generating devices for vibration and acoustic testing. The invention is especially useful in vibration testing.

### Background to the Invention

Power amplifiers for use in driving, for example, electro-dynamic shakers must be capable of stable operation with a wide range of electrical loads, offer low distortion, make efficient use of electrical power, be compact in design and allow for computer control.

The use of switch-mode power technology in such amplifiers provides many advantages over linear amplification techniques and are available presently in a range of 5 to 300 kVA. The use of switch-mode power technology dramatically improves amplifier efficiency over linear amplifiers, thus reducing power losses. This allows air cooling of semi-conductor heatsinks, as opposed to water cooling. A reduced output semi-conductor component count for switch-mode designs increases reliability also. By using computer operation and control of switching modulations, lower total harmonic distortion figures may be established.

A standard switch-mode amplifier approach is to use a single half-bridge at high frequency (for examples 150kHz). To reduce distortion from the amplifier a feedback path is applied. The amount of feedback which can be applied however is limited by the switching frequency of the individual switching elements. To obtain lower distortion a higher switching frequency should be used as this allows more feedback. However, in the half-bridge topology, as the switching frequency increases the losses in the power switches increase. This reduces efficiency. Specialised high frequency switching elements may be used but these are inherently expensive. Thus, a compromise is established between the cost of the high frequency switching elements allowable distortion and the output power.

We acknowledge the disclosure in XP001055906 (Nielsen), AES 102^{nd} Conv. 1997 Munich; XP000800140 (Robinson), 1998 IEE; XP01024167 (Watanabe et al), 1997 IEEE; and XP010366646 (Takano et al), 1999 IEE of parallel-connected interlaced PWM amplifiers. The last of these includes a current feedback patch across the load, and is in accordance with the pre-characterising portion of claim 1.

It is an object of the present invention to alleviate the disadvantages associated with prior art amplification techniques and to provide a switch-mode power amplifier having a controllable high frequency output.

### Summary of the Invention

Accordingly, the present invention provides a switch-mode power amplifier circuit according to claim 1.

The sequencing of the half-bridge outputs to generate an interlaced output facilitates the reduction of the switching frequency of individual switching components within the half-bridges while at least maintaining the overall operation frequency of the circuit. For *N* half-bridges operating at *f*kHz, the overall operational frequency of the circuit is *Nf*kHz. Alternatively, the switching frequency of individual switching elements of a system operating at *f*okHz may be reduced by a factor of *N.* The use of plural units allows for higher power levels, paralleling the units within the voltage feedback loop, whilst the channel feedback loops ensure each unit carries the same current. Any plural number of units may be used.

Preferably, the summation of the half-bridge network outputs includes the feedback signal.

Conveniently, where the operating frequency of the circuit is increased, further feedback may be imposed on the circuit to reduce distortion.

Advarttageously, the half-bridge networks are arranged in a push-pull configuration about the load. This configuration defines a left and right channel for which a power drive signal may be derived to generate timing signals for controlling individual switching elements of the half-bridge networks.

Preferably, a timing strategy is used to ensure current sharing between the networks.

Preferably, each half-bridge network comprises two switching elements in opposite switched states. Conveniently, the states are a high impedance state representing "OFF" and a low impedance state representing "ON".

Preferably, an identical supply voltage is supplied to each half-bridge network.

The switched power outputs of the half-bridge networks are preferably provided with an in-line inductance. Preferably, the inductance is identical for each output.

An output filter stage is preferably provided on the circuit. Preferably at least part of the filter is shunt-connected across the load in use.

A current sensor is preferably provided on the output of each half-bridge network so that a current error signal can be derived. The error signal is preferably compared with a plurality of waveforms to give a timing signal to regulate the switching of the half-bridge switching elements.

The switching of the half-bridge switching elements is preferably controlled using Pulse Width Modulation (PWM) techniques.

The use of a plurality of power devices, operating in an interlaced fashion, in order to increase the apparent operating frequency of the system, allows more feedback to be imposed on the system.

The invention is applicable to any system where high power, low distortion waveforms are required to drive a load, particularly an electromagnetic load, with a high degree of control.

### Brief Description of the Drawings

The invention will now be described more particularly with reference to the accompanying drawings which show, by way of example only, two embodiments of switch-mode power amplifier according to the invention. In the drawings:
Figure 1 is a schematic circuit diagram of a prior art standard switching amplifier incorporating a half-bridge network;
Figure 2 is a schematic circuit diagram similar to that of Figure 1 incorporating two half-bridge networks in a push-pull configuration;
Figure 3 is a schematic circuit diagram of a switching amplifier according to a first embodiment of the invention incorporating three half-bridge networks;
Figure 4 is a waveform diagram illustrating the individual and combined output currents of the half-bridge networks of Figure 3;
Figure 5a and 5b are schematic circuit diagrams of half-bridge networks showing details of the switching elements;
Figure 6 is a schematic circuit diagram of a power stage of a switch-mode amplifier according to a second embodiment of the invention having N pairs of half-bridge networks in a push-pull configuration;
Figure 7 is a schematic waveform diagram showing the output current 1 to the load for an amplifier having three pairs of half-bridge networks;
Figure 8 is a schematic diagram of a current feedback circuit for generating an error signal; and
Figure 9 is a schematic overview of a high frequency switch-mode power amplifier according to the invention.

### Detailed Description of the Preferred Embodiment

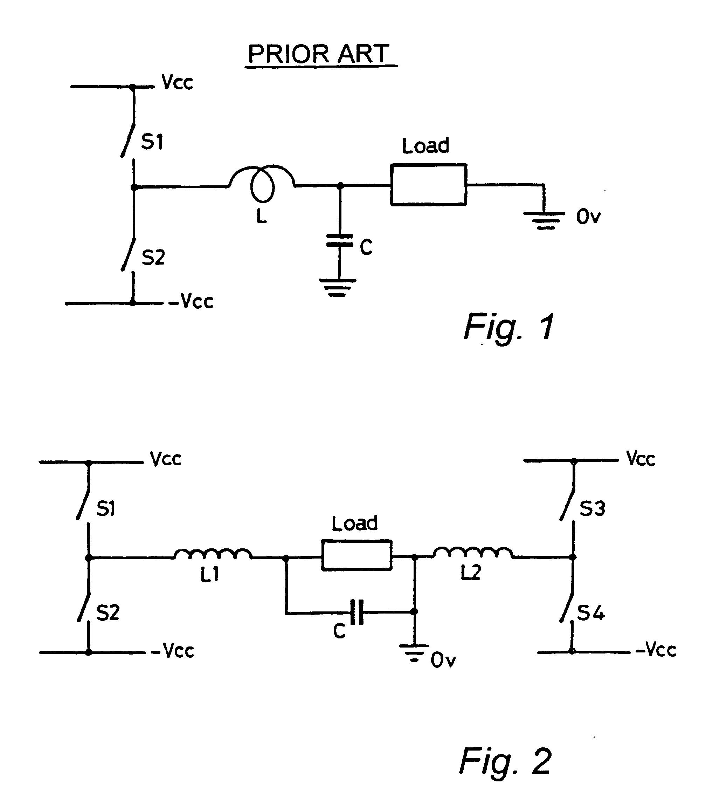

Referring to the drawings and initially to the prior art arrangements of Figures 1 and 2, a standard switching amplifier comprising a single half-bridge is shown in Figure 1. The switching elements S1, S2 are operated at high frequency, for example, 150kHz, each element being in the opposite switched state to the other. If the first switching element S1 is conducting or in a low impedance mode, that is, "ON", then the second switching element S2 is not conducting or is in a high impedance state, that is "OFF". In the particular application considered (driving an electromagnetic load), it is important that amplifier distortion is kept to a minimum. To achieve this, feedback is applied. The amount of feedback which can be applied is limited by the switching frequency of the switching elements. An increase in the switching frequency allows more feedback to be applied and thus decreases distortion. Unfortunately, high speed switching creates heating problems, increases losses in the switches and the associated risk of component failure increases. Additionally, the high speed switching of individual components increases the incidence of radio frequency interference necessitating shielding which adds to the overall cost of the amplifier.

A push-pull configuration, as illustrated in Figure 2, comprising a pair of half-bridges, overcomes some of the disadvantages discussed hereinabove. By adding a half-bridge comprising a usually identical pair of switching elements S3, S4 to the other side of the load, each side or channel can operate at 75kHz giving an overall switching frequency of 150kHz. Thus, the decreased switching speed of the switching elements S1, S2, S3, S4 ensure losses and distortion are kept to a minimum while the overall high operating frequency of the circuit allows greater feedback.

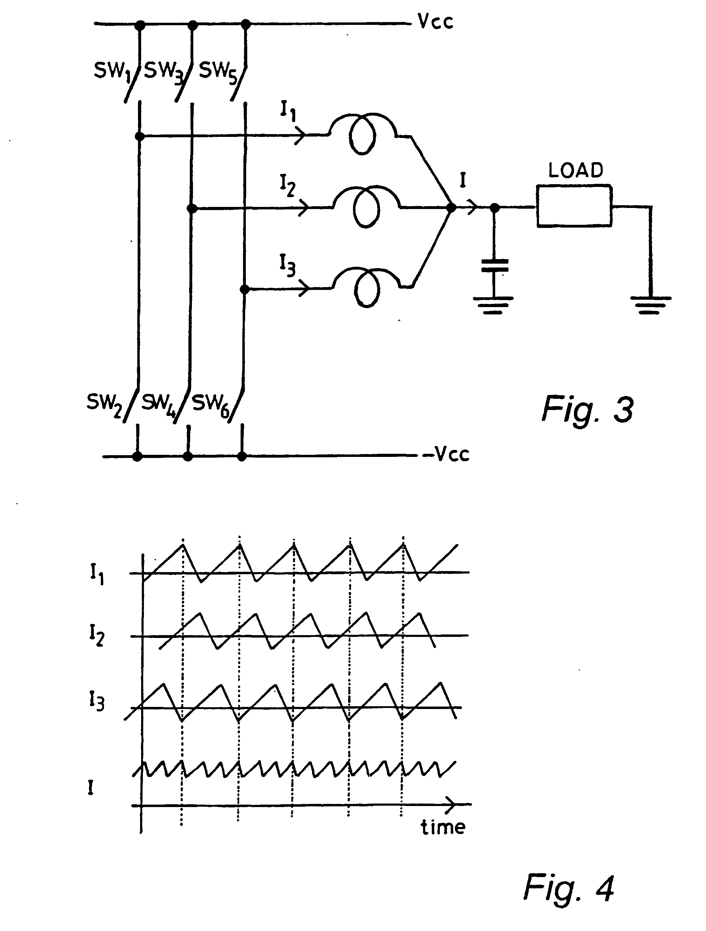

Referring now to Figure 3, the first embodiment of the invention comprises a switch-mode power amplifier having three half-bridge networks, each operating at one third of the overall operating frequency required. The first half-bridge comprises switching elements SW₁, SW₂ generating a current profile I₁ passed through a first inductor L₁ to a summation point P. The second half-bridge comprises switching elements SW₃, SW₄ generating a current profile I₂ passed through a second inductance L₂ to the summation point P and the third half-bridge comprises usually identical switching elements SW₅, SW₄ generating a current profile I₃ passed through a third inductance L₃ to the summation point P. These profiles I₁, I₂, I₃ are combined by a summation element (not shown) to give a final current profile I, as shown in Figure 4, which is applied to the load. From this current characteristic I, which has a higher ripple frequency than any of the source current profiles I₁, I₂, I₃, it will be appreciated that substantially more feedback may be applied to this circuit to reduce distortion of the amplifier.

In the above arrangement, three half-bridges each operating at a relatively low frequency of 50kHz results in an apparent switching frequency of 150kHz at the load. Thus, identical amplifier performance can be achieved with lower switching losses.

It will further be appreciated that by increasing the number of half-bridge networks in this circuit, the overall operating frequency can be increased with no real overall increase in distortion and that feedback can be increased to further decrease distortion. Optionally, or concurrently, the power rating of the switching elements may be increased and their operating speeds decreased. Thus, *N* half-bridges operating at a switching frequency of *f* kHz gives an apparent switching frequency of *Nf* kHz. Alternatively, a required frequency of *fo* may be achieved by using *N* half-bridges operating at an Nth factor of the overall switching frequency *fo.*

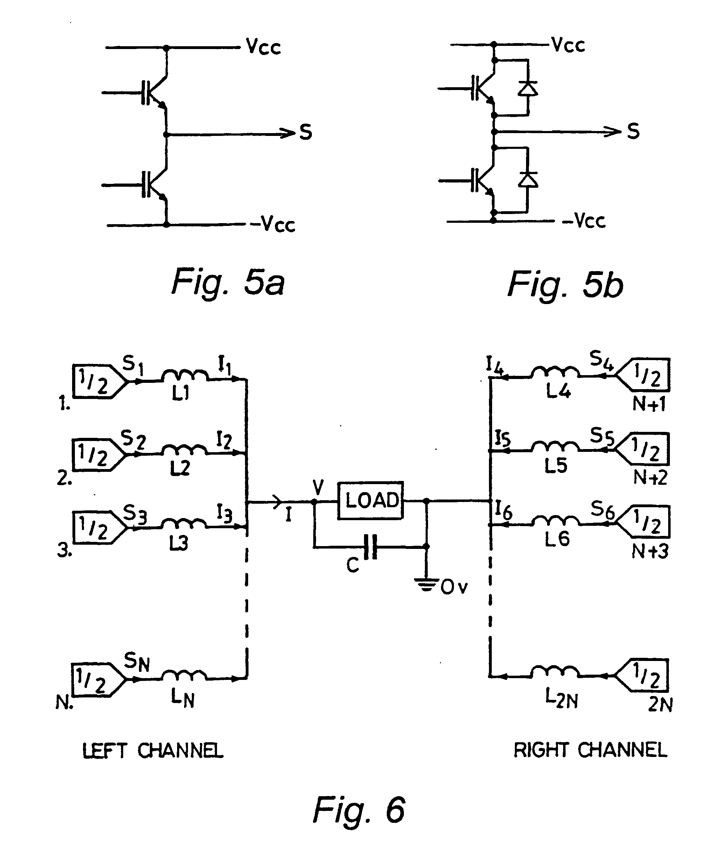

Figures 5a and 5b are illustrations of suggested switching elements in a half-bridge configuration. Any switching element suitable for relatively high speed, high power application may be used. Generally, MOSFET or IGBT elements are preferred. Gate or base current is provided to the switching elements from timing circuitry (not shown) which is normally controlled using Pulse Width Modulation (PWM) techniques.

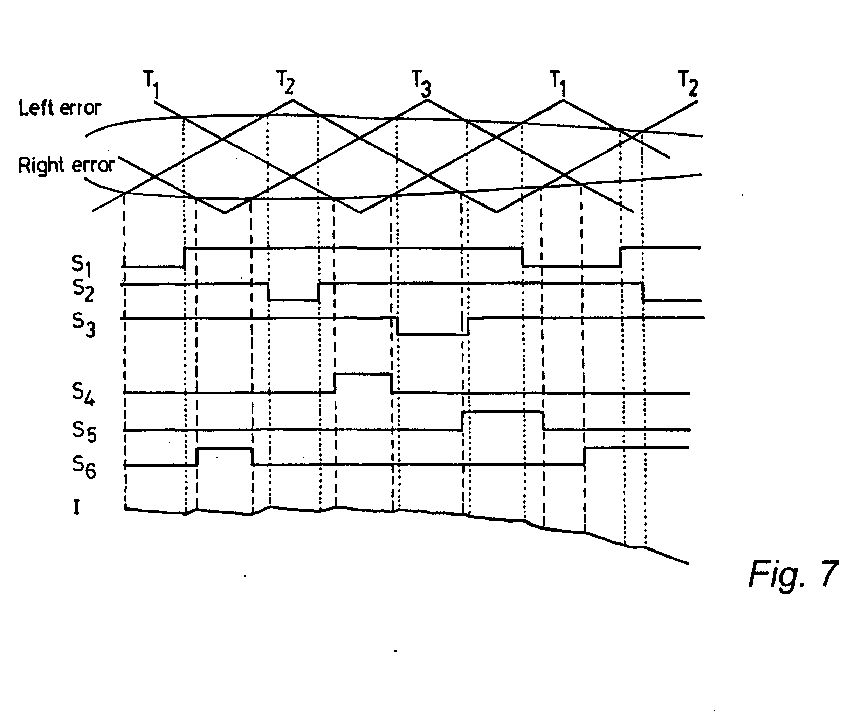

In Figure 6, the half-bridge networks (denoted generally as ½) are arranged in a push-pull configuration with *N* pairs of half-bridges, one of each pair being provided on either side of the load to define a left channel and a right channel. Taking the left channel, each half-bridge has an output S which is passed through an inductance L before the output is combined at a summation point (or rail) to produce the channel output supplied to the load. The combined output of the left and right channels to the load, which has a capacitor C connected in parallel thereto, gives the system output current I. In the embodiment of the invention, each channel has three half-bridges, the left channel having switching profiles S₁, S₂, S₃ and output currents I₁, I₂, I₃, passed through inductors L₁, L₂, L₃ and the right channel has switching profiles S₄, S₅, S₆, and output currents I₄, I₅, I₆ passed through inductors L₄, L₅, L₆. The switching profiles S₁, S₂, S₃, S₄, S₅, S₆, and the system output current characteristics I are shown in Figure 7 which is discussed in more detail hereinafter.

The amplifier topology preferred is such that it may be separated into discrete elements including the power stage, supplying the load, the voltage feedback circuit, the current feedback circuit and the PWM circuitry. The power stage of the circuitry is comprised of six identical half-bridge structures, each of which comprises two IGBT's as shown for example in Figure 5B. In this arrangement, when the top device is "ON" (in a low impedance state), the opposing device is "OFF" (in a high impedance state), and *vice versa*. The supply to each half-bridge is identical and not connected to ground (earth).

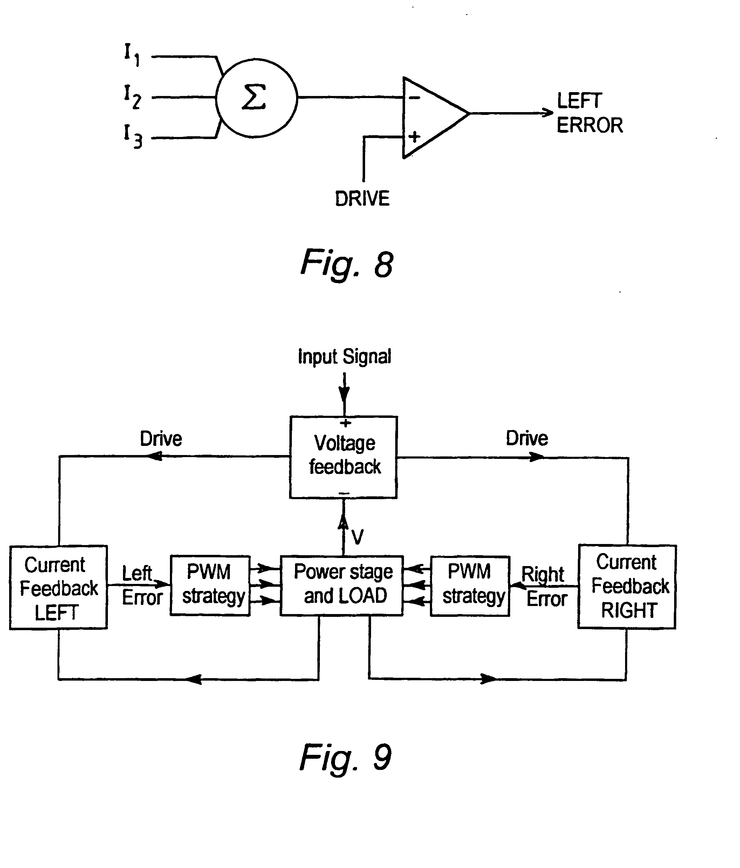

The currents I₁, I₂, I₃, I₄, I₅, I₆, through the six inductors L₁, L₂, L₃, L₄, L₅, L₆ are measured by current sensors, giving signals which are then summed, as shown in Figure 8, for comparison with a drive signal. The currents I₁, I₂, I₃ on the left channel are summed and compared to produce a "left error" signal. An identical process occurs with the currents I₄, I₅, I₆ on the opposite side, read through the corresponding inductors L₄, L₅, L₆. The current signals are summed as before for comparison but are inverted before producing the "right error" signal.

Referring now to Figure 7, the "left error" and "right error" signals are compared, with three triangular waves T₁, T₂, T₃ which are equally spaced in time. When the left error signal exceeds the first triangular wave T₁, the output of the first half-bridge of the left channel S₁ is driven high, and when the signal falls below the triangular wave T₁ the output S₁ is driven low. This is true also for the signal profiles of the second and third triangular waves T₂, T₃ and outputs of the second and third half-bridge networks S₂, S₃. respectively. The right error signal is also compared, as shown in Figure 7, with the same triangular waves T₁, T₂, T₃, such that when the right error signal exceeds the first triangular wave T₁, the output of the first half-bridge of the right channel S₄ is driven high. When the signal falls below the triangular wave, the output S₄ is driven low. This is also true for the relationship between the second and third triangular waves T₂, T₃, and the second and third right channel half-bridge outputs S₅, S₆, respectively.

The inductors L₁, L₂, L₃, L₄, L₅, L₆ facilitate the integration of the sum of the left channel output currents (I₁ + I₂ + I₃) less the sum of the right-hand output currents and the load voltage (I₄ + I₅ + I₆ + V). This gives a smoothed output current I, as shown in Figure 7, with transitions at every half-bridge state change. Thus, the rate of change of inductor current alters six times as often as any of the half-bridge outputs alter. The capacitor C in parallel with the load combines with the individual inductors L₁, L₂, L₃, L₄, L₅, L₆ to form a low pass filter. This ensures that little of the overall switching frequency is observed at the load.

The drive signal, shown in Figure 8, is created by subtracting the load voltage V from the input signal. This drive signal is identical for creating both right and left current feedback signals.

There are six current transducers/sensors so the currents through each inductor are measured. In this way any imbalance in the current levels in the inductors can be calculated. If any inductor has any more current in it than the overall mean (average current), then the associated half-bridge has its timing adjusted to correct for this imbalance. This process is achieved as is the overall control strategy using a digital control method.

The overall strategy of the amplifier is shown in Figure 9. The input signal is used to create left and right channel "drive" signals in a voltage feedback circuit. The drive signals are passed to the current feedback circuits, as illustrated in Figure 8. The error signals are passed to timing circuits shown as "PWM strategy" which generates timing signals to the half-bridge switching elements.

In accordance with the invention, to provide higher power levels than can be obtained from one set of six half-bridges, multiple units are used. This is possible by paralleling units inside the voltage feedback loop such that each unit receives the same drive signal and is connected identically to the load. The current feedback loops ensure that all units carry identical current loads. In this way, any quantity of units may be paralleled.

It will be appreciated that at lower speeds, higher currents can be switched with greater ease. This also facilitates the use of cheaper high power switching elements. The topology of the invention facilitates production of a power amplifier having a kVA rating double that previously available at substantially the same cost. Additionally, as specified in the preferred embodiment, an amplifier with two sets of three half-bridges, each operating at 25kHz, gives them apparent operating frequency of 150kHz at the load. Cheaper switching elements operating at slower speeds and capable of handling high currents can be used as speeds well within their optimum range, decreasing the incidence of component failure and increasing the overall reliability of the amplifier.

Radio frequency interference is also reduced as the reduced switching frequency allows lower voltage transients (dv/dt) without substantially affecting efficiency.

The term "electromagnetic load" as used herein may be applied to audio speakers, electric motors to which high quality waveforms are to be applied and signal generating devices used in connection with vibration and acoustic testing. The invention is however more particularly directed to electro-dynamic shakers used for vibration testing.

It will of course be understood that the invention is not limited to the specific details described herein, which are given by way of example only, and that various modifications and alterations are possible within the scope of the invention.

## Claims

1. A switch-mode power amplifier circuit connectable to an electromagnetic load, the circuit comprising a unit comprising a plurality of half-bridge networks having outputs (S₁...S_{N}) combined for summation at a summation point, the half-bridge networks being switched to provide power outputs sequenced to generate an interlaced output at the summation point which is operably connected to a load so that for a given switching frequency of the networks the operational frequency of the circuit is increased; and a current feedback path provided so that a feedback signal is generated;
**characterised in that** the circuit comprises a plural quantity of said units, each unit being a set of plural half-bridge networks as aforesaid, the units being connected in parallel inside a voltage feedback loop between a drive signal input and the load, such that each unit receives, in use, a common drive signal, is connected identically to the load and is controlled to carry the same current, whereby to provide a required output power level.

2. A switch-mode power amplifier circuit as claimed in claim 1, in which the sequencing of the half-bridge outputs to generate an interlaced output facilitates the reduction of the switching frequency of individual switching components within the half-bridges while at least maintaining the overall operational frequency of the circuit.

3. A switch-mode power amplifier circuit as claimed in either claim 1 or claim 2, in which, for *N* half-bridges operating at *f* kHz, the overall operational frequency of the circuit is *Nf*kHz.

4. A switch-mode power amplifier circuit as claimed in either claim 1 or claim 2, in which, for *N* half-bridges, the switching frequency of individual switch elements of a system operating at *fo*kHz may be reduced by a factor of *N*.

5. A switch-mode power amplifier circuit as claimed in any preceding claim, in which the summation of the half-bridge network outputs includes the feedback signal.

6. A switch-mode power amplifier circuit as claimed in either claim 4 or claim 5, in which, where the operating frequency of the circuit is increased, further feedback may be imposed on the circuit to reduce distortion.

7. A switch-mode power amplifier circuit as claimed in any one of the preceding claims in which the or each unit of half-bridge networks is arranged in a push-pull configuration about the load, the configuration defining a left and right channel for which a power drive signal may be derived to generate timing signals for controlling individual switching elements of the half-bridge networks, each channel being a current feedback path.

8. A switch-mode power amplifier circuit as claimed in any one of the preceding claims, in which a timing strategy is used to ensure current sharing between the networks.

9. A switch-mode power amplifier circuit as claimed in any one of the preceding claims, in which each half-bridge network comprises two switching components in opposite switched states.

10. A switch-mode power amplifier circuit as claimed in claim 9, in which the states are a high impedance state representing "OFF" and a low impedance state representing "ON".

11. A switch-mode power amplifier circuit as claimed in any one of the preceding claims, in which an identical supply voltage is supplied to each half-bridge network.

12. A switch-mode power amplifier circuit as claimed in any one of the preceding claims, in which the switched power outputs of the half-bridge networks are provided with an in-line inductance (L₁...L_{2N}).

13. A switch-mode power amplifier circuit as claimed in claim 12, in which the inductance is identical for each output.

14. A switch-mode power amplifier circuit as claimed in any one of the preceding claims, in which an output filter state is provided on the circuit, at least part of which is shunt-connected across a load in use.

15. A switch-mode power amplifier circuit as claimed in any one of the preceding claims, in which a current sensor is provided on the output of each half-bridge network so that a current error signal can be derived.

16. A switch-mode power amplifier circuit as claimed in claim 15, in which the error signal is compared with a plurality of waveforms to give a timing signal to regulate the switching of the half-bridge switching elements.

17. A switch-mode amplifier circuit as claimed in any one of claims 2 to 16, in which the switching of the half-bridge switching components is controlled using Pulse Width Modulation (PWM) techniques.

18. A switch-mode power amplifier circuit as claimed in any one of the preceding claims, in which the use of a plurality of power devices operating in an interlaced fashion, in order to increase the apparent operating frequency of the system, allows more feedback to be imposed on the system.

19. A switch-mode power amplifier circuit as claimed in any one of the preceding claims, in which the system is used to drive a load, particularly an electromagnetic load, using high power, low distortion waveforms with a high degree of control.

## Patentansprüche

1. Schaltmodus-Leitungsverstärkerschaltung, die mit einer elektromagnetischen Last verbindbar ist, wobei die Schaltung eine Einheit umfasst, die eine Vielzahl von Halbbrücken-Netzwerken mit Ansgängen (S₁ ... S_{N}) kombiniert für eine Summation an einem Summationspunkt umfasst, wobei die Halbbrücken-Netzwerke geschaltet werden, um Leistungsausgänge bereitzustellen, deren Abfolge derart ist, dass sie einen verschachtelten Ausgang an dem Summationspunkt erzeugen, der betriebsmäßig mit einer Last verbunden ist, so dass für eine gegebene Schaltfrequenz der Netzwerke die Betriebsfrequenz der Schaltung erhöht wird; und einen Stromrückkopplungspfad, der so bereitgestellt ist, dass ein Rückkopplungssignal erzeugt wird,
**dadurch gekennzeichnet, dass** die Schaltung mehrere der besagten Einheiten umfasst, wobei jede Einheit ein Satz von mehreren Halbbrücken-Netzwerken, wie voranstehend erwähnt ist, wobei die Einheiten innerhalb einer Spannungsrückkopplungsschleife zwischen einem Ansteuersignaleingang und der Last parallel geschaltet sind, so dass jede Einheit bei der Verwendung ein gemeinsames Ansteuersignal empfängt, identisch mit der Last verbunden ist und gesteuert wird, um den gleichen Strom zu führen, wodurch ein erforderlicher Ausgangsleistungspegel bereitgestellt wird.

2. Schaltmodus-Leistungsverstärkerschaltung nach Anspruch 1, bei der die Abfolge der Halbbrücken-Ausgängen zum Erzeugen eines verschachtelten Ausgangs die Verringerung der Schaltfrequenz von einzelnen Schaltkomponenten innerhalb der Halbbrücken erleichtert, während die Gesamtbetriebsfrequenz der Schaltung wenigstens aufrechterhalten wird.

3. Schaltmodus-Leistungsverstärkerschaltung nach entweder Anspruch 1 oder Anspruch 2, bei der für N-Halbbrücken, die bei *f* kHz arbeiten, die Gesamtbetriebsfrequenz der Schaltung Schaltung N*f* kHz ist.

4. Schaltmodus-Leistungsverstärkerschaltung nach entweder Anspruch 1 oder Anspruch 2, bei der für N-Halbbrücken die Schaltfrequenz von einzelnen Schaltelementen eines Systems, welches bei *fok* Hz arbeitet, um einen Faktor von N verringert werden kann.

5. Schaltmodus-Leistungsverstärkerschaltung nach irgendeinem vorangehenden Anspruch, bei der die Summation der Halbbrücken-Netzwerkausgänge das Rückkopplungssignal einschließt.

6. Schaltmodus-Leistungsverstärkerschaltung nach entweder Anspruch 4 oder Anspruch 5, bei der, wenn die Betriebsfrequenz der Schaltung erhöht wird, eine weitere Rückkopplung auf die Schaltung auferlegt werden kann, um eine Verzerrung zu verringern.

7. Schaltmodus-Leistungsverstärkerschaltung nach irgendeinem der vorangehenden Ansprüche, bei der die oder jede Einheit von Halbbrücken-Netzwerken in einer Gegentaktkonfiguration um die Last herum angeordnet ist, wobei die Konfiguration einen linken und einen rechten Kanal definiert, für den ein Leistungsansteuersignal abgeleitet werden kann, um Timingsignale zum Steuern von einzelnen Schaltelementen der Halbbrücken-Netzwerke zu erzeugen, wobei jeder Kanal ein Stromrückkopplungspfad ist.

8. Schaltmodus-Leistungsverstärkerschaltung nach irgendeinem der vorangehenden Ansprüche, bei der eine Timingstrategie verwendet wird, um eine Stromaufteilung zwischen den Netzwerken sicherzustellen.

9. Schaltmodus-Leistungsverstärkerschaltung nach irgendeinem der vorangehenden Ansprüche, bei der jedes Halbbrücken-Netzwerk zwei Schaltkomponenten in entgegengesetzt geschalteten Zuständen umfasst.

10. Schaltmodus-Leistungsverstärkerschaltung nach Anspruch 9, bei der die Zustände ein hoher Impedanzzustand, der "AUS" darstellt, und ein niedriger Impedanzzustand, der "EIN" darstellt, sind.

11. Schaltmodus-Leistungsverstärkerschaltung nach irgendeinem der vorangehenden Ansprüche, bei der eine identische Energieversorung an jedes Halbbrücken-Netzwerk geführt wird.

12. Schaltmodus-Leistungsverstärkerschaltung nach irgendeinem der vorangehenden Ansprüche, bei der die geschalteten Leistungsausgänge der Halbbrücken-Netzwerke mit einer in-line Induktivität (L₁ ... L_{2N}) versehen sind.

13. Schaltmodus-Leistungsverstärkerschaltung nach Anspruch 12, bei der die Induktivität für jeden Ausgang identisch ist.

14. Schaltmodus-Leistungsverstärkerschaltung nach irgendeinem der vorangehenden Ansprüche, bei der ein Ausgangsfilterzustand an der Schaltung bereitgestellt wird, wobei wenigstens ein Teil davon über einer Last bei der Verwendung über einen Nebenschluss verbunden ist.

15. Schaltmodus-Leistungsverstärkerschaltung nach irgendeinem der vorangehenden Ansprüche, bei der ein Stromsensor auf dem Ausgang jedes Halbbrücken-Netzwerks vorgesehen ist, so dass ein Stromfehlersignal abgeleitet werden kann.

16. Schaltmodus-Leistungsverstärkerscaltung nach Anspruch 15, bei der das Fehlersignal mit einer Vielzahl von Wellenformen verglichen wird, um ein Timingsignal zu ergeben, um den Schaltvorgang der Halbbrücken-Schaltelemente zu regeln.

17. Schaltmodus-Leistungsverstärkerschaltung nach irgendeinem der Ansprüche 2 bis 16, bei der der Schaltvorgang der Halbbrücken-Schaltkomponenten unter Verwendung von Impuls-Breiten-Modulations-(PBM)-Techniken gesteuert wird.

18. Schaltmodus-Leistungsverstärkerschaltung nach irgendeinem der vorangehenden Ansprüche, bei der die Verwendung einer Vielzahl von Leistungseinrichtungen, die in einer verschachtelten Weise arbeiten, um die aufscheinende Betriebsfrequenz des Systems zu erhöhen, erlaubt, dass mehr Rückkopplung auf das System auferlegt wird.

19. Schaltmodus-Leistungsverstärkerschaltung nach irgendeinem der vorangehenden Ansprüche, bei der das System verwendet wird, um eine Last, insbesondere eine elektromagnetische Last, unter Verwendung von Wellenformen mit hoher Leistung und niedriger Verzerrung mit einem hohen Steuerungsgrad anzusteuern.

## Revendications

1. Circuit amplificateur de puissance à mode de commutation pouvant être connecté à une charge électromagnétique, le circuit comprenant une unité comprenant plusieurs réseaux à demi-pont, ayant des sorties (S₁...S_{N}) combinées en vue d'une sommation au niveau d'un point de sommation, les réseaux à demi-pont étant commutés pour établir des sorties de puissance mises en séquence pour produire une sortie entrelacée au niveau du point de sommation, connectée en service à une charge, de sorte qu'en présence d'une fréquence de commutation définie des réseaux, la fréquence opérationnelle du circuit est accrue; et un parcours à courant de réaction établi de sorte à produire un signal de réaction;
**caractérisé en ce que** le circuit comprend plusieurs desdites unités, chaque unité étant constituée par un groupe de plusieurs réseaux à demi-pont, comme décrit ci-dessus, les unités étant connectées en parallèle à l'intérieur d'une boucle à réaction de tension, entre une entrée de signal d'entraînement et la charge, de sorte que chaque unité reçoit en service un signal d'entraînement commun, est connectée de manière identique à la charge et est contrôlée de sorte à transférer le même courant, pour établir ainsi un niveau de puissance de sortie requis.

2. Circuit amplificateur de puissance à mode de commutation selon la revendication 1, dans lequel le séquencement des sorties à demi-pont pour produire une sortie entrelacée facilite en outre la réduction de la fréquence de commutation des composants de commutation individuels dans les demi-ponts, tout en maintenant au moins la fréquence opérationnelle globale du circuit.

3. Circuit amplificateur de puissance à mode de commutation selon les revendications 1 ou 2, dans lequel, pour *N* demi-ponts fonctionnant à *fk* Hz, la fréquence opérationnelle globale du circuit correspond à *Nf* kHz.

4. Circuit amplificateur de puissance à mode de commutation selon les revendications 1 ou 2, dans lequel, pour *N* demi-ponts, le fréquence de commutation des éléments de commutation individuels d'un système fonctionnant à *fo*k Hz peut être réduite d'un facteur de *N*.

5. Circuit amplificateur de puissance à mode de commutation selon l'une quelconque des revendications précédentes, dans lequel la sommation des sorties des réseaux à demi-pont englobe le signal de réaction.

6. Circuit amplificateur de puissance à mode de commutation selon l'une des revendications 4 ou 5, dans lequel,la fréquence opérationnelle du circuit étant accrue, une réaction accrue peut être imposée au circuit pour réduire la distorsion.

7. Circuit amplificateur de puissance à mode de commutation selon l'une quelconque des revendications précédentes, dans lequel la ou chaque unité de réseaux à demi-pont est agencée dans une configuration symétrique autour de la charge, la configuration définissant un canal de gauche et de droite pour lesquels un signal d'entraînement de puissance peut être dérivé pour produire des signaux de synchronisation afin de contrôler les éléments de commutation individuels des réseaux à demi-pont, chaque canal constituant un parcours à réaction de courant.

8. Circuit amplificateur de puissance à mode de commutation selon l'une quelconque des revendications précédentes, dans lequel une stratégie de synchronisation est appliquée pour assurer un partage du courant entre les réseaux.

9. Circuit amplificateur de puissance à mode de commutation selon l'une quelconque des revendications précédentes, dans lequel chaque réseau à demi-pont comprend deux composants de commutation dans des états de commutations opposés.

10. Circuit amplificateur de puissance à mode de commutation selon la revendication 9, dans lequel les états sont constitués par un état haute impédance représentant l'état « débranché » et un état à faible impédance représentant l'état « branché ».

11. Circuit amplificateur de puissance à mode de commutation selon l'une quelconque des revendications précédentes, dans lequel une tension d'alimentation identique est fournie à chaque réseau à demi-pont.

12. Circuit amplificateur de puissance à mode de commutation selon l'une quelconque des revendications précédentes, dans lequel les sorties de puissance commutées des réseaux à demi-pont sont établies avec une inductance en ligne (L₁...L_{2N}).

13. Circuit amplificateur de puissance à mode de commutation selon la revendication 12, dans lequel l'inductance est identique pour chaque sortie.

14. Circuit amplificateur de puissance à mode de commutation selon l'une quelconque des revendications précédentes, dans lequel un état de filtrage de sortie est établi sur le circuit, au moins une partie correspondante étant connectée par dérivation à travers une charge en service.

15. Circuit amplificateur de puissance à mode de commutation selon l'une quelconque des revendications précédentes, dans lequel un détecteur de courant est agencé sur la sortie de chaque réseau à demi-pont, de sorte à pouvoir dériver un signal d'erreur de courant.

16. Circuit amplificateur de puissance à mode de commutation selon la revendication 15, dans lequel le signal d'erreur est comparé avec plusieurs formes d'onde pour produire un signal de synchronisation afin de régler la commutation des éléments de commutation à demi-pont.

17. Circuit amplificateur de puissance à mode de commutation selon l'une quelconque des revendications 2 à 16, dans lequel la commutation des composants de commutation à demi-pont est contrôlée par des techniques de modulation d'impulsions en durée (PWM).

18. Circuit amplificateur de puissance à mode de commutation selon l'une quelconque des revendications précédentes, dans lequel l'utilisation de plusieurs dispositifs de puissance fonctionnant de manière entrelacée, en vue d'accroître la fréquence opérationnelle apparente du système, permet d'imposer une réaction accrue au système.

19. Circuit amplificateur de puissance à mode de commutation selon l'une quelconque des revendications précédentes, dans lequel le système sert à entraîner une charge, en particulier une charge électromagnétique, par l'intermédiaire de formes d'onde haute puissance et à distorsion réduite avec un degré de contrôle élevé.
